# EUROPEAN PATENT SPECIFICATION

(11) **EP 3 923 004 B1**
(45) Date of publication and mention of the grant of the patent: **09.11.2022**
(21) Application number: 19918369.0
(22) Date of filing: 22.03.2019
(51) Int. Cl.: G01R 31/12, G01R 31/14

(54) **RESONANT MUTUAL INDUCTANCE PARTIAL DISCHARGE DETECTION DEVICE AND DETECTION METHOD FOR CABLE JOINT**
VORRICHTUNG ZUR DETEKTION VON TEILENTLADUNG MIT RESONANTER GEGENSEITIGER INDUKTANZ UND DETEKTIONSVERFAHREN FÜR KABELVERBINDUNG
DISPOSITIF DE DÉTECTION DE DÉCHARGE PARTIELLE À INDUCTANCE MUTUELLE RÉSONANTE ET PROCÉDÉ DE DÉTECTION POUR RACCORD DE CÂBLE

(30) Priority: 01.03.2019 CN 201910156572
(43) Date of publication of application: 15.12.2021
(73) Proprietor: Zhejiang New Tuwei Electronics Technology Co., Ltd., Hangzhou, Zhejiang 310012 (CN)
(72) Inventor: ZHANG, Shiyuan, Hangzhou, Zhejiang 310012 (CN); HE, Shaolin, Hangzhou, Zhejiang 310012 (CN); WU, Chengcai, Hangzhou, Zhejiang 310012 (CN)
(74) Representative: Petculescu, Ana-Maria
(86) International application number: PCT/CN2019/079203
(87) International publication number: WO 2020/177158

(56) References cited:
- CN-A- 103 884 970
- CN-A- 106 124 940
- CN-A- 106 353 579
- CN-A- 106 353 579
- CN-A- 106 980 075
- CN-A- 108 459 247
- CN-U- 204 832 432
- DE-B3-102007 015 490
- JP-A- H04 337 481
- JP-A- H04 337 481
- US-A- 5 323 117
- US-A1- 2002 125 877
- US-A1- 2015 285 849
- US-B1- 6 297 645

## Description

### Field

The present invention relates to the technical field of high-voltage cable partial discharge detection, in particular to a resonant mutual inductance partial discharge detection device and detection method for cable joint.

### Background

High-voltage cables serve as blood vessels for a city, providing energy required for city life. Once a cable fails, impact on city life is immeasurable. A main fault location of the high-voltage cable is a high-voltage cable joint. Performing well high-voltage cable joint detection is key point to ensure stable operation of the high-voltage cable.

A partial discharge problem of the high-voltage cable is a major factor in causing high-voltage cable accidents, and has been concerned widely over the years. A partial discharge point of the cable joint is mainly concentrated on a silicone rubber of the high-voltage cable. If a specific position of the partial discharge may be located at a rubber insulating layer of the cable joint, the fault problem of the rubber layer of the cable joint may be analyzed by data, and the weak links of the rubber layer of the cable joint may be found out, which is conducive to the production of products with better qualified rate.

A invention with application No. 201710225831.2 of the same applicant discloses a mesh differential partial discharge detection device for cable joint, which comprises a signal detection unit and a signal processing unit, the signal detection unit and the signal processing unit are provided at a cable joint, the signal detection unit is a mesh capacitor signal detection unit, namely, the signal detection unit is of a mesh structure, and adopts a multi-slice distributed layout to form an angle difference; the signal processing unit processes a plurality of sets of signals transmitted by the signal detection unit by adopting a differential detection principle. The partial discharge detection device of the invention effectively solves a technical problem that a traditional capacitor cannot have a small capacitance value when a large detection region is provided, and solves a technical problem of detecting an effective partial discharge signal from a clutter signal and locating a partial discharge position at the same time. But the signal processing unit of the invention is composed of an ADC acquisition chip and a signal processing single-chip microcomputer, because a partial discharge sensor is provided inside a copper shell of the high-voltage cable joint which belongs to an armored voltage layer of the cable and has a voltage-withstand requirement with a grounding zero voltage, so that a signal line of the partial discharge sensor cannot be pulled out to place the ADC acquisition chip and the signal processing single-chip microcomputer outside the cable. If the signal processing unit is placed inside the cable, changes to the original cable joint are relatively large, service life of an electronic component is not as long as that of the cable, and the signal processing unit cannot be repaired after the signal processing unit is damaged. Additional art concerned with partial discharge detection in cables, bushings, and cable joints, is found in DE102007015490, US5323117, US2002/125877, US2015/285849, US6297645, CN106353579, and JPH04337481.

### Summary

In order to solve the above-mentioned technical problems, the present invention proposes a resonant mutual inductance partial discharge detection device and detection method for cable joint.

A resonant mutual inductance partial discharge detection device for cable joint, comprising a partial discharge acquisition sensor and a partial discharge signal processor, further comprises a partial discharge signal resonance output unit and a partial discharge signal resonance acquisition unit, the partial discharge acquisition sensor and the partial discharge signal resonance output unit are in wired connection and are provided inside a sheath voltage-withstand layer of the cable joint, the partial discharge signal resonance output unit and the partial discharge signal resonance acquisition unit are in wireless connection, and the partial discharge signal resonance acquisition unit and the partial discharge signal processor are in wired connection and are provided outside the sheath voltage-withstand layer of the cable joint.

Preferably, the partial discharge acquisition sensor is a capacitive partial discharge acquisition sensor and made of a flexible PCB.

In any of the above solutions, it is preferred that the capacitive partial discharge acquisition sensor is provided with a mesh capacitor detection region.

In any of the above solutions, it is preferred that a mesh structure of a capacitor includes a circular mesh structure and/or a polygonal mesh structure, but not limited to the circular mesh structure and the polygonal mesh structure, the capacitor also adopts other mesh structures.

In any of the above solutions, it is preferred that the mesh capacitor detection region of the capacitive partial discharge acquisition sensor is made of a conductive material.

In any of the above solutions, it is preferred that the conductive material comprises copper.

In any of the above solutions, it is preferred that the capacitive partial discharge acquisition sensor is provided with a plurality of mesh capacitor detection regions, the mesh capacitor detection regions are wrapped outside a rubber layer and inside of a copper mesh layer of the cable joint in an array structure and a distributed layout manner forming angle shifts.

In any of the above solutions, it is preferred that the flexible PCB for making the capacitive partial discharge acquisition sensor adopts a double-layer structure, wherein the layer close to the rubber layer of the cable adopts a mesh structure, and the layer close to the copper mesh layer of the cable adopts an integral one-piece structure.

In any of the above solutions, it is preferred that the number of the mesh capacitor detection regions in the capacitive partial discharge acquisition sensor wrapping a certain cable joint is an even number, and two detection regions opposite to each other constitute one group.

In any of the above solutions, it is preferred that the partial discharge signal resonance output unit and the partial discharge signal resonance acquisition unit both comprise a shell, an electromagnetic shielding layer and a coil layer, and the electromagnetic shielding layer and the coil layer are provided inside the shell.

In any of the above solutions, it is preferred that the coil layer is inductance coils dispose on a PCB using an array structure.

In any of the above solutions, it is preferred that at a certain cable joint, the number of the inductance coils in the partial discharge signal resonance output unit, the number of the inductance coils in the partial discharge signal resonance acquisition unit, and the number of the mesh capacitor detection regions in the capacitive partial discharge acquisition sensor are the same.

In any of the above solutions, it is preferred that a resonant circuit is formed by the inductance coil in the partial discharge signal resonance output unit and the capacitor in the capacitive partial discharge acquisition sensor.

In any of the above solutions, it is preferred that the inductance coil in the partial discharge signal resonance acquisition unit is matched with the capacitor, and a signal transmitted by the partial discharge signal resonance output unit is received through mutual inductance between the inductance coil in the partial discharge signal resonance acquisition unit and the inductance coil in the partial discharge signal resonance output unit.

In any of the above solutions, it is preferred that the inductance coils adopt a double-coil structure and a reverse winding manner, and constraint magnetic line of force loops.

In any of the above solutions, it is preferred that the electromagnetic shielding layer is made of a ferrite material.

In any of the above solutions, it is preferred that the partial discharge signal resonance output unit and the partial discharge signal resonance acquisition unit both adopt an integrated injection molding structure, and the shells thereof are both provided with an IP68 waterproof structure.

In any of the above solutions, it is preferred that the shell is provided with a wire outlet, and a rubber plunger is arranged at the wire outlet and is used for waterproofing.

In any of the above solutions, it is preferred that the partial discharge signal resonance output unit is provided at a copper shell glue filling port of the cable and is used for transmitting a partial discharge signal to an outside of an outer sheath voltage-withstand layer of the cable.

In any of the above solutions, it is preferred that the partial discharge signal resonance acquisition unit is provided outside the outer sheath voltage-withstand layer of the cable and corresponds to a position of the partial discharge signal resonance output unit.

In any of the above solutions, it is preferred that the partial discharge signal processor collects detection signals of the capacitive partial discharge acquisition sensor through the partial discharge signal resonance output unit and the partial discharge signal resonance acquisition unit.

In any of the above solutions, it is preferred that the partial discharge signal processor comprises at least one of a FPGA and a single-chip microcomputer.

In any of the above solutions, it is preferred that the partial discharge signal processor processes the acquired signals to obtain signal strength in frequency domain.

In any of the above solutions, it is preferred that the partial discharge signal processor processes signal difference of the capacitor grouped, and positions an occurrence position of the partial discharge by analyzing the signal strength.

In any of the above solutions, it is preferred that the partial discharge signal processor uploads the position of the partial discharge to a server.

In any of the above solutions, it is preferred that a connection line of the partial discharge signal resonance acquisition unit and the partial discharge signal processor is an electromagnetic shielding signal line.

Another aspect of the present invention provides a resonant mutual inductance partial discharge detection method for cable joint for detecting partial discharge at the cable joint, the method comprises steps:
providing the resonance mutual inductance partial discharge detection device for cable joint;
the resonance mutual inductance partial discharge detection device for cable joint detecting the partial discharge signal, and positioning an occurrence position of the partial discharge.

Preferably, the capacitive partial discharge acquisition sensor is provided outside the rubber layer and inside the copper mesh layer of the cable joint, and wraps the cable joint.

In any of the above solutions, it is preferred that the partial discharge signal resonance output unit is provided at the copper shell glue filling port of the cable for transmitting the partial discharge signal to the outside of the outer sheath voltage-withstand layer of the cable.

In any of the above solutions, it is preferred that the partial discharge signal resonance acquisition unit is provided outside the outer sheath voltage-withstand layer of the cable and corresponds to the position of the partial discharge signal resonance output unit.

In any of the above solutions, it is preferred that the step of the resonant mutual inductance partial discharge detection device for cable joint detects the partial discharge signal, and positions an occurrence position of the partial discharge further comprises:
the capacitive partial discharge acquisition sensor acquiring the partial discharge signal;
the partial discharge signal resonance output unit and the capacitive partial discharge acquisition sensor generating resonance, and transmitting the partial discharge signal to the outside of the outer sheath voltage-withstand layer of the cable;
the partial discharge signal resonance acquisition unit receiving the signal output to the outside of the outer sheath voltage-withstand layer of the cable by the partial discharge signal resonance output unit;
the partial discharge signal processor processes the signals acquired by the partial discharge signal resonance acquisition unit and positions an occurrence position of the partial discharge.

In any of the above solutions, it is preferred that the partial discharge signal processor uploads the position of the partial discharge to the server.

The resonant mutual inductance partial discharge detection device and detection method for cable joint provided by the present invention may wirelessly transmit a partial discharge signal to the outside of an insulating layer of the cable with no damage of voltage-withstand requirement between an armored voltage layer of the cable and a grounding zero voltage; meanwhile because only a part of the detection device is provided inside the cable, the change of the original cable joint is small, so the original waterproof and voltage-withstand process of the cable joint is reserved; no semiconductor electronic element is arranged in the insulating layer of the cable joint, so the service life of components in the insulating layer of the cable joint is ensured to be longer than the service life of the cable; and is safe and reliable.

### Brief description of the drawings

FIG. 1 is a schematic structural diagram of a preferred embodiment of a resonant mutual inductance partial discharge detection device for cable joint according to the present invention.
FIG. 2 is a tiled schematic diagram of a preferred embodiment of a capacitive partial discharge acquisition sensor of the embodiment shown in FIG. 1 of the resonant mutual inductance partial discharge detection device for cable joint according to the present invention.
FIG. 3 is an installation cross-sectional schematic diagram of the embodiment shown in FIG. 2 of the capacitive partial discharge acquisition sensor of the resonant mutual inductance partial discharge detection device for cable joint according to the present invention.
FIG. 4 is an exploded diagram of a preferred embodiment of a partial discharge signal resonance output unit of the embodiment shown in FIG. 1 of the resonant mutual inductance partial discharge detection device for cable joint according to the present invention.
FIG. 5 is an exploded diagram of a preferred embodiment of a partial discharge signal resonance acquisition unit of the embodiment shown in FIG. 1 of the resonant mutual inductance partial discharge detection device for cable joint according to the present invention.
FIG. 6 is a schematic diagram of a preferred embodiment of a coil layer in the partial discharge signal resonance output unit and the partial discharge signal resonance acquisition unit of the resonant mutual inductance partial discharge detection device for cable joint according to the present invention.
FIG. 7 is a schematic diagram of constraining magnetic line of force loops by coils of the partial discharge signal resonance output unit and the partial discharge signal resonance acquisition unit of the resonant mutual inductance partial discharge detection device for cable joint according to the present invention.
FIG. 8 is a flow diagram of a preferred embodiment of a resonant mutual inductance partial discharge detection method for cable joint according to the present invention.

### Detailed description of the embodiments

For better understanding of the present invention, detailed description of the invention is provided below with reference to specific embodiments.

### Embodiment 1

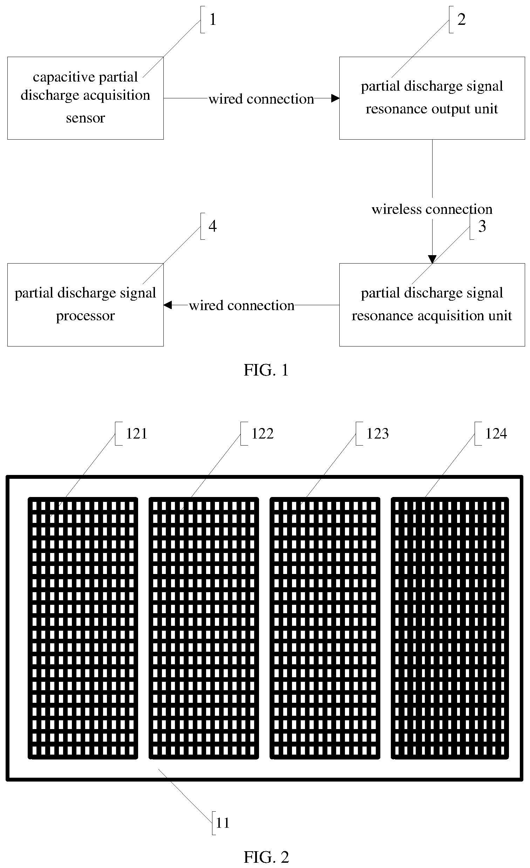

As shown in FIG. 1, a resonant mutual inductance partial discharge detection device for cable joint comprises a capacitive partial discharge acquisition sensor 1, a partial discharge signal resonant output unit 2, a partial discharge signal resonance acquisition unit 3 and a partial discharge signal processor 4, the capacitive partial discharge acquisition sensor 1 and the partial discharge signal resonance output unit 2 are in wired connection and provided inside a sheath voltage-withstand layer of the cable joint, the partial discharge signal resonance output unit 2 and the partial discharge signal resonance acquisition unit 3 are in wireless connection, and the partial discharge signal resonance acquisition unit 3 and the partial discharge signal processor 4 are in wired connection and provided outside the sheath voltage-withstand layer of the cable joint.

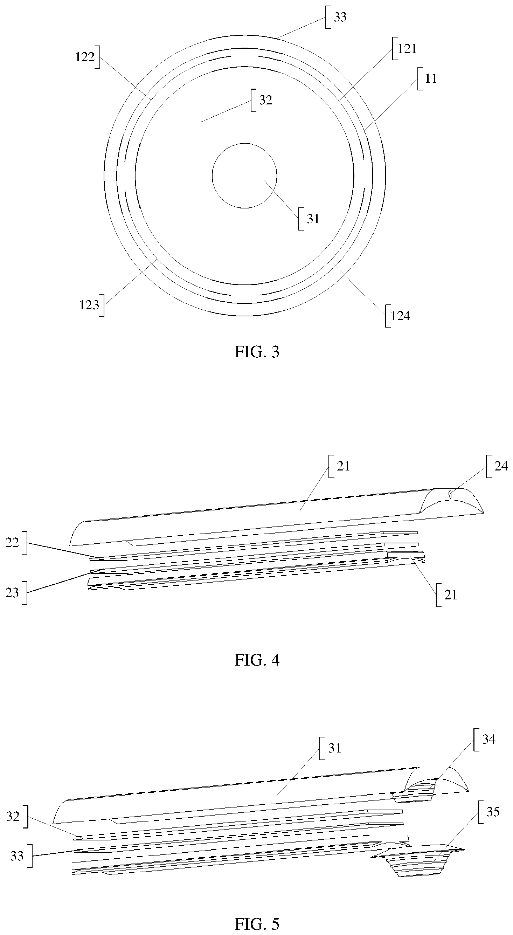

As shown in FIG. 2 and FIG. 3, the capacitive partial discharge acquisition sensor 1 is made of a flexible PCB (FPC), and is provided with a mesh capacitor detection region which is made of conductive material copper. The capacitive partial discharge acquisition sensor 1 is provided outside a rubber layer 32 and inside a copper mesh layer 33 of the cable joint, the rubber layer 32 wraps a conductor wire core 31 of the cable. The flexible PCB for making the capacitive partial discharge acquisition sensor is a double-layer structure, wherein the layer close to the rubber layer 32 of the cable is a mesh structure formed by copper wires and has four mesh capacitor detection regions 121, 122, 123 and 124, and the layer close to the copper mesh layer 33 of the cable is an integral one-piece structure 11 made of a copper sheet. The mesh capacitor detection regions in the capacitive partial discharge acquisition sensor are wrapped around the cable joint in an array structure and a distributed layout manner forming angle shifts. The two mesh capacitor detection regions opposite to each other constitute one group, which means the mesh capacitor detection regions 121 and 123 are one group, the mesh capacitor detection regions 122 and 124 are one group. In the capacitive partial discharge acquisition sensor 1, the layer close to the copper mesh layer 33 of the cable is a copper sheet integral one-piece structure 11, so that the copper mesh layer of the cable joint does not affect the capacitor area, and therefore the capacitance value is not affected; the layer close to the rubber layer 32 of the cable is the mesh structure, so that the capacitor can be ensured to have a relatively small capacitance value while having a relatively large wrapping area around the cable joint. When there are fewer partial discharge charges, there may be a relatively high voltage value that is easy to be detected according to the charge amount Q = C ^{∗} V. The capacitive partial discharge acquisition sensor 1 is made of a flexible double-layer PCB (FPC), so that the two-layer spacing of the capacitor can be strictly controlled, and it is ensured that the capacitance value does not deviate due to installation and a measurement result is not influenced.

As shown in FIG. 4, the partial discharge signal resonance output unit 2 comprises a shell 21, a coil layer 22 and an electromagnetic shielding layer 23, the electromagnetic shielding layer 23 and the coil layer 22 are provided inside the shell 21. The coil layer 22 is inductance coils provided on a PCB using an array structure. At a certain cable joint, the number of the inductance coils in the partial discharge signal resonance output unit 2 is consistent with the number of capacitors in the capacitive partial discharge acquisition sensor 1 provided thereat, that is, consistent with the number of the mesh capacitor detection regions. The inductance coils are a double-coil structure and adopt a reverse winding manner, each set of inductance coils is connected with a mesh capacitor detection region to form a resonant circuit. The electromagnetic shielding layer 23 is made of a ferrite material. The partial discharge signal resonance output unit 2 adopts an integrated injection molding structure, its shell 21 is provided with an IP68 waterproof structure, a wire outlet 24 is provided on the shell 21. A connecting line of the coil layer and the capacitor detection region is led out through the wire outlet 24. A rubber plunger is further arranged at the wire outlet 24 for waterproofing. The partial discharge signal resonance output unit 2 is provided at a copper shell glue filling port of the cable in a heat shrinkable tube at the cable joint for transmitting a partial discharge signal to an outside of an outer sheath voltage-withstand layer of the cable.

As shown in FIG. 5, the partial discharge signal resonance acquisition unit 3 comprises a shell 31, a coil layer 32 and an electromagnetic shielding layer 33, the electromagnetic shielding layer 33 and the coil layer 32 are provided inside the shell 31. The coil layer 32 is inductance coils dispose on a PCB using an array structure. At a certain cable joint, the number of inductance coils in the partial discharge signal resonance acquisition unit 3 is consistent with the number of capacitors in the capacitive partial discharge acquisition sensor 1 provided thereat, that is, consistent with the number of the mesh capacitor detection regions. The inductance coils are a double-coil structure and adopt a reverse winding manner, each set of inductance coils is matched with the capacitor to receive signals transmitted by the inductance coils in the partial discharge signal resonance output unit 2. The electromagnetic shielding layer 33 is made of a ferrite material. The partial discharge signal resonance acquisition unit 3 adopts an integrated injection molding structure, its the shell 31 is provided with an IP68 waterproof structure, a wire outlet 34 is provided on the shell 31, a connecting line of the coil layer and the partial discharge signal processor is led out through the wire outlet 34. A rubber plunger 35 is further arranged at the wire outlet 34 for waterproofing. The partial discharge signal resonance acquisition unit 3 is provided outside the outer sheath voltage-withstand layer of the cable and corresponds to a position of the partial discharge signal resonance output unit, and the inductance coils thereof is matched with the capacitor, receiving the signals transmitted by the partial discharge signal resonance output unit 2 through mutual inductance between the inductance coils thereof and the inductance coils in the partial discharge signal resonance output unit 2.

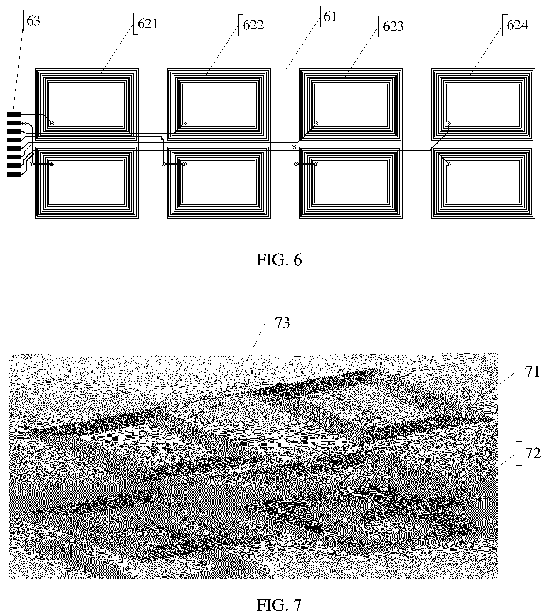

As shown in FIG. 6, the coil layers of the partial discharge signal resonant output unit 2 and the partial discharge signal resonance acquisition unit 3 both include four sets of inductance coils, which are respectively inductance coils 621, inductance coils 622, inductance coils 623, and inductance coils 624, which are arranged on the PCB 61 in an array structure. Connecting wires are respectively led out from two ends of the inductance coils, a connecting end 63 is formed at one end of the PCB 61, the connecting end 63 has eight connecting endpoints, wherein the top two connecting endpoints correspond to two ends of the inductance coils 621, and each lower two connecting endpoints correspond to two ends of the inductance coils 622, 623, and 624 respectively. The inductance coils are a double-coil structure and adopt a reverse winding manner, and constraint magnetic line of force loops. For the coil layer in the partial discharge signal resonance output unit 2, the inductance coils 621 are connected to two sides of the capacitor detection region 121 through the connecting end 63, the inductance coils 622 are connected to two sides of the capacitor detection region 122 through the connecting end 63, the inductance coils 623 are connected to the two sides of the capacitor detection region 123 through the connecting end 63, and the inductance coils 624 are connected to two sides of the capacitor detection region 124 through the connecting end 63, and a resonant circuit is respectively formed after each group of inductance coils connects with each capacitor. For the coil layer in the partial discharge signal resonance acquisition unit 3, it is connected with the partial discharge signal processor 4 through the connecting end 63 to transmit the signals to the partial discharge signal processor 4.

The principle that the inductance coils constraint the magnetic line loops of force is shown in FIG. 7, magnetic lines of force 73 pass out from one coil of the inductance coils 71 in the partial discharge signal resonance output unit 2, pass in another coil of the inductance coils 71, and then pass out from one coil of the inductance coils 72 in the partial discharge signal resonance acquisition unit 3, and then pass in the other coil of the inductance coils 72, thereby forming a closed loop, so as to constrain the magnetic lines of force 73.

The partial discharge signal processor 4 comprises an FPGA and/or a single-chip microcomputer, and processes a signal of the partial discharge signal resonance acquisition unit 3 by a Fourier transform after receiving the signal, and obtains the signal strength in frequency domain by a fast Fourier transform (FFT) and/or a discrete Fourier transform (DFT), etc. Because a high-voltage cable is long, current is lager and there are many high-frequency harmonics, when the cable is in a normal working, cable harmonics will cause interference to the capacitive partial discharge acquisition sensor 1, so that the valid partial discharge signal is submerged in the cable clutter, therefore, the partial discharge signal processor 4 processes the signal in a differential manner, that is, calculating a signal difference of the capacitors grouped. On one hand, interference signals of the cable may be uniformly absorbed by the mesh capacitor detection regions which wrap the cable, the signal values of the capacitors grouped are the same, and there is no difference, the interference signals may be well filtered off, and on the other hand, for the partial discharge signal, charges escape from the cable core to the copper mesh layer of the cable, a voltage difference is formed by charging a detection region of the capacitive sensor, and there is no voltage difference formed on the other capacitor detection region in group, thus there is a signal difference, and the position of the partial discharge may be located by analyzing which capacitor detection region detects the voltage difference. The partial discharge signal processor 4 uploads the position of the partial discharge to a server. Meanwhile, the discharge intensity may be uploaded, a worker may perform timely maintenance on the cable according to a detection result, and the occurrence of cable faults is reduced.

### Embodiment 2

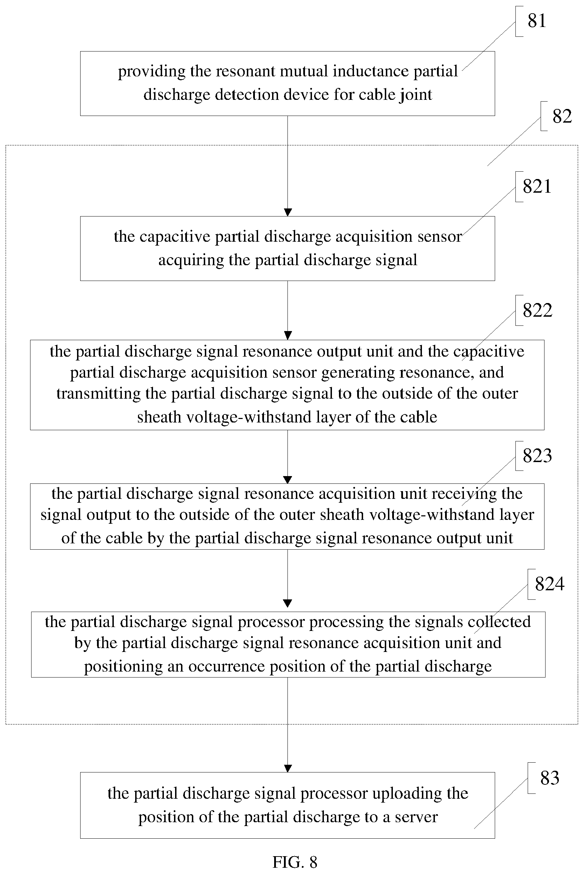

A resonant mutual inductance partial discharge detection method for cable joint, as shown in FIG. 8, comprises:
step 81: providing a resonant mutual inductance partial discharge detection device for cable joint;
step 82: the resonant mutual inductance partial discharge detection device for cable joint detecting the partial discharge signal, and positioning an occurrence position of the partial discharge;
step 83: the partial discharge signal processor uploading the occurrence position of the partial discharge to a server.

In the step 81, the capacitive partial discharge acquisition sensor is provided outside the rubber layer and inside the copper mesh layer of the cable joint; the partial discharge signal resonance output unit is provided at the copper shell glue filling port of the cable for transmitting the partial discharge signal to the outside of the outer sheath voltage-withstand layer of the cable; the partial discharge signal resonance acquisition unit is provided outside the outer sheath voltage-withstand layer of the cable and corresponds to the position of the partial discharge signal resonance output unit. The capacitive partial discharge acquisition sensor and the partial discharge signal resonance acquisition unit are in wired connection, the partial discharge signal resonance output unit and the partial discharge signal acquisition unit are in wireless connection, the partial discharge signal resonance acquisition unit and the partial discharge signal processor are in wired connection, and the connection line thereof is an electromagnetic shielding signal line.

The step 82 further comprises:
step 821: the capacitive partial discharge acquisition sensor acquiring the partial discharge signal;
step 822: the partial discharge signal resonance output unit and the capacitive partial discharge acquisition sensor generating resonance, and transmitting the partial discharge signal to the outside of the outer sheath voltage-withstand layer of the cable;
step 823: the partial discharge signal resonance acquisition unit receiving the signal output to the outside of the outer sheath voltage-withstand layer of the cable by the partial discharge signal resonance output unit;
step 824: the partial discharge signal processor processing the signals acquired by the partial discharge signal resonance acquisition unit and positioning the occurrence position of the partial discharge.

### Embodiment 3

A mesh structure of the capacitor in the capacitive partial discharge acquisition sensor comprises a polygonal mesh structure such as a triangular mesh structure, a square mesh structure, a rectangular mesh structure, a regular hexagonal mesh structure and so on, and/or a circular mesh structure, but is not limited to the polygonal mesh structure and the circular mesh structure, the mesh structure may also be an irregular mesh structure or a combination of several mesh structures.

In order to process the signal by means of a differential method for the partial discharge signal processor, the number of the mesh capacitor detection regions in the capacitive partial discharge acquisition sensor is an even number. In order to perform more accurate location of the position of the partial discharge, the number of mesh capacitor detection regions can be increased, and the number of inductance coils in the partial discharge signal resonance output unit and the partial discharge signal resonance acquisition unit should be correspondingly increased.

It should be noted that the above embodiments are only used to illustrate the technical solutions of the present invention, but not to limit them; although the foregoing embodiments have been described in detail, those skilled in the art should understand that they can modify recorded technical solutions in the foregoing embodiments while remaining within the scope of the invention, which is defined by the claims.

## Claims

1. A resonant mutual inductance partial discharge detection device for cable joint, comprising a partial discharge acquisition sensor (1) and a partial discharge signal processor (4), **characterized in that** it further comprises a partial discharge signal resonance output unit (2) and a partial discharge signal resonance acquisition unit (3), the partial discharge acquisition sensor and the partial discharge signal resonance output unit are in wired connection and provided inside a sheath voltage-withstand layer of the cable joint, the partial discharge signal resonance output unit and the partial discharge signal resonance acquisition unit are in wireless connection, and the partial discharge signal resonance acquisition unit and the partial discharge signal processor are in wired connection and provided outside the sheath voltage-withstand layer of the cable joint.

2. The resonant mutual inductance partial discharge detection device for cable joint according to claim 1, **characterized in that**, the partial discharge signal resonance output unit is provided at a copper shell glue filling port of a cable for transmitting a partial discharge signal to an outside of an outer sheath voltage-withstand layer of the cable; the partial discharge signal resonance acquisition unit is provided outside the outer sheath voltage-withstand layer of the cable and corresponds to a position of the partial discharge signal resonance output unit.

3. The resonant mutual inductance partial discharge detection device for cable joint according to claim 1, **characterized in that**, the partial discharge signal resonance output unit and the partial discharge signal resonance acquisition unit both adopt an integrated injection molding structure and both comprise a shell, an electromagnetic shielding layer and a coil layer, and the electromagnetic shielding layer and the coil layer are provided inside the shell; the coil layer is inductance coils provided on a PCB using an array structure; the inductance coils adopt a double-coil structure and a reverse winding manner, and constraint magnetic line loops of force; the electromagnetic shielding layer is made of a ferrite material; the shell is provided with an IP68 waterproof structure; the shell is provided with a wire outlet, and a rubber plunger is arranged at the wire outlet and is used for waterproofing.

4. The resonant mutual inductance partial discharge detection device for cable joint according to claim 1, **characterized in that**, the partial discharge acquisition sensor is a capacitive partial discharge acquisition sensor, is made of a flexible PCB, and is provided with a plurality of mesh capacitor detection regions, the mesh capacitor detection regions are wrapped outside a rubber layer and inside a copper mesh layer of the cable joint in an array structure and a distributed layout manner forming angle shifts; the flexible PCB for making the capacitive partial discharge acquisition sensor adopts a double-layer structure, wherein the layer close to the rubber layer of the cable adopts a mesh structure, and the layer close to the copper mesh layer of the cable adopts an integral one-piece structure; the number of the mesh capacitor detection regions in the capacitive partial discharge acquisition sensor wrapping a certain cable joint is an even number, and two detection regions opposite to each other constitute one group; a mesh structure of the capacitor includes a circular mesh structure and/or a polygonal mesh structure, but not limited to the circular mesh structure and the polygonal mesh structure, the capacitor also adopts other mesh structures.

5. The resonant mutual inductance partial discharge detection device for cable joint according to claims 3 or 4, **characterized in that**, a resonant circuit is formed by the inductance coil in the partial discharge signal resonance output unit and the capacitor in the capacitive partial discharge acquisition sensor, the inductance coil in the partial discharge signal resonance acquisition unit is matched with capacitor, and a signal transmitted by the partial discharge signal resonance output unit is received through mutual inductance between the inductance coil in the partial discharge signal resonance acquisition unit and the inductance coil in the partial discharge signal resonance output unit, at a certain cable joint, the number of the inductance coils in the partial discharge signal resonance output unit, the number of the inductance coils in the partial discharge signal resonance acquisition unit, and the number of the mesh capacitor detection regions in the capacitive partial discharge acquisition sensor are the same.

6. The resonant mutual inductance partial discharge detection device for cable joint according to claim 1, **characterized in that**, the partial discharge signal processor acquires detection signals of the capacitive partial discharge acquisition sensor through the partial discharge signal resonance output unit and the partial discharge signal resonance acquisition unit, the partial discharge signal processor comprises at least one of a FPGA and a single-chip microcomputer, the partial discharge signal processor processes the signals collected to obtain signal strength in frequency domain; the partial discharge signal processor processes signal difference of the capacitor grouped, and positions an occurrence position of the partial discharge by analyzing the signal strength.

7. The resonant mutual inductance partial discharge detection device for cable joint according to claim 1, **characterized in that**, a connection line of the partial discharge signal resonance acquisition unit and the partial discharge signal processor is an electromagnetic shielding signal line.

8. A resonant mutual inductance partial discharge detection method for cable joint, being for detecting partial discharge at the cable joint, **characterized in that** it comprises the following steps:
providing a resonant mutual inductance partial discharge detection device for cable joint according to any one of claims 1-7;
the resonant mutual inductance partial discharge detection device for cable joint detecting the partial discharge signal, and positioning an occurrence position of the partial discharge .

9. The resonant mutual inductance partial discharge detection method for cable joint according to claim 8, **characterized in that**, the capacitive partial discharge acquisition sensor is provided outside the rubber layer and inside the copper mesh layer of the cable joint, and wraps the cable joint; the partial discharge signal resonance output unit is provided at the copper shell glue filling port of the cable and is used for transmitting the partial discharge signal to the outside of the outer sheath voltage-withstand layer of the cable; the partial discharge signal resonance acquisition unit is provided outside the outer sheath voltage-withstand layer of the cable and corresponds to the position of the partial discharge signal resonance output unit.

10. The resonant mutual inductance partial discharge detection method for cable joint according to claim 9, **characterized in that**, the step of " the resonant mutual inductance partial discharge detection device for cable joint detecting the partial discharge signal, and positioning an occurrence position of the partial discharge" further comprises:
the capacitive partial discharge acquisition sensor acquiring the partial discharge signal;
the partial discharge signal resonance output unit and the capacitive partial discharge acquisition sensor generating resonance, and transmitting the partial discharge signal to the outside of the outer sheath voltage-withstand layer of the cable;
the partial discharge signal resonance acquisition unit receiving the signal output to the outside of the outer sheath voltage-withstand layer of the cable by the partial discharge signal resonance output unit;
the partial discharge signal processor processing the signals acquired by the partial discharge signal resonance acquisition unit and positioning an occurrence position of the partial discharge.

## Patentansprüche

1. Teilentladungserkennungsvorrichtung mit gegenseitiger Resonanzinduktanz für eine Kabelverbindung, umfassend einen Teilentladungserfassungssensor (1) und einen Teilentladungssignalprozessor (4), ferner **dadurch gekennzeichnet, dass** sie eine Teilentladungssignalresonanzausgabeeinheit (2) und eine Teilentladungssignalresonanzerfassungseinheit (3) umfasst, wobei der Teilentladungserfassungssensor und die Teilentladungssignalresonanzausgabeeinheit in verdrahteter Verbindung stehen und innerhalb einer spannungsfesten Hüllschicht der Kabelverbindung bereitgestellt sind, die Teilentladungssignalresonanzausgabeeinheit und die Teilentladungssignalresonanzerfassungseinheit in drahtloser Verbindung stehen, und die Teilentladungssignalresonanzerfassungseinheit und der Teilentladungssignalprozessor in verdrahteter Verbindung stehen und außerhalb der spannungsfesten Hüllschicht der Kabelverbindung bereitgestellt sind.

2. Teilentladungserkennungsvorrichtung mit gegenseitiger Resonanzinduktanz für eine Kabelverbindung nach Anspruch 1, **dadurch gekennzeichnet, dass** die Teilentladungssignalresonanzausgabeeinheit an einer Kupfermantelklebstoffeinfüllöffnung eines Kabels zum Übertragen eines Teilentladungssignal aus einer äußeren spannungsfesten Hüllschicht des Kabels heraus bereitgestellt ist; die Teilentladungssignalresonanzerfassungseinheit außerhalb der äußeren spannungsfesten Hüllschicht des Kabels bereitgestellt ist und einer Position der Teilentladungssignalresonanzausgabeeinheit entspricht.

3. Teilentladungserkennungsvorrichtung mit gegenseitiger Resonanzinduktanz für eine Kabelverbindung nach Anspruch 1, **dadurch gekennzeichnet, dass** die Teilentladungssignalresonanzausgabeeinheit und die Teilentladungssignalresonanzerfassungseinheit beide eine einstückige Spritzgussstruktur aufweisen und beide einen Mantel, eine elektromagnetische Schirmungsschicht und eine Spulenschicht umfassen, und die elektromagnetische Schirmungsschicht und die Spulenschicht innerhalb des Mantels bereitgestellt sind; es sich bei der Spulenschicht um an einer PCB unter Verwendung einer Array-Struktur bereitgestellte Induktionsspulen handelt; die Induktionsspulen eine Doppelwindungsstruktur mit umgekehrter Wicklung und einschränkende Magnetkraftlinienschleifen aufweisen; die elektromagnetische Schirmungsschicht aus einem Ferritmaterial hergestellt ist; der Mantel mit einer wasserfesten Struktur gemäß IP68 bereitgestellt ist; der Mantel mit einem Drahtausgang versehen ist und ein Gummistopfen für Wasserfestigkeit an dem Drahtausgang angeordnet ist.

4. Teilentladungserkennungsvorrichtung mit gegenseitiger Resonanzinduktanz für eine Kabelverbindung nach Anspruch 1, **dadurch gekennzeichnet, dass** der Teilentladungserfassungssensor ein kapazitiver Teilentladungserfassungssensor ist, aus einer flexiblen PCB hergestellt ist und mit einer Vielzahl von Gitterkondensatorerkennungsbereichen versehen ist, wobei die Gitterkondensatorerkennungsbereiche in einer Array-Struktur mit verteiltem Layout unter Bindung von Winkelverschiebungen um eine Gummischicht und innerhalb einer Kupfergitterschicht der Kabelverbindung gewickelt sind; wobei die flexible PCB zum Bilden des kapazitiven Teilentladungserfassungssensors eine Doppelschichtstruktur aufweist, wobei die Schicht nah an der Gummischicht des Kabels eine Gitterstruktur aufweist und die Schicht nah an der e Kupfergitterschicht des Kabels eine einstückige Struktur aufweist; wobei die Anzahl der Gitterkondensatorerkennungsbereiche in dem kapazitiven Teilentladungserfassungssensor, die eine bestimmte Kabelverbindung umwickeln, gerade ist und je zwei einander gegenüberliegende Erkennungsbereiche eine Gruppe bilden; wobei eine Gitterstruktur des Kondensators eine kreisförmige Gitterstruktur und/oder eine polygonale Gitterstruktur beinhaltet, aber nicht auf die kreisförmige Gitterstruktur und die polygonale Gitterstruktur beschränkt ist und der Kondensator auch andere Gitterstrukturen aufweist.

5. Teilentladungserkennungsvorrichtung mit gegenseitiger Resonanzinduktanz für eine Kabelverbindung nach Anspruch 3 oder 4, **dadurch gekennzeichnet, dass** eine Resonanzschaltung durch die Induktionsspule in der Teilentladungssignalresonanzausgabeeinheit und den Kondensator in dem kapazitiven Teilentladungserfassungssensor gebildet ist, die Induktionsspule in der Teilentladungssignalresonanzerfassungseinheit mit dem Kondensator übereinstimmt und ein durch die Teilentladungssignalresonanzausgabeeinheit übertragenes Signal durch die gegenseitige Induktion zwischen der Induktionsspule in der Teilentladungssignalresonanzerfassungseinheit und der Induktionsspule in der Teilentladungssignalresonanzausgabeeinheit empfangen wird, wobei an einer bestimmten Kabelverbindung die Anzahl der Induktionsspulen in der Teilentladungssignalresonanzausgabeeinheit, die Anzahl der Induktionsspulen in der Teilentladungssignalresonanzerfassungseinheit und die Anzahl der Gitterkondensatorerkennungsbereiche in dem kapazitive Teilentladungserfassungssensorgleich ist.

6. Teilentladungserkennungsvorrichtung mit gegenseitiger Resonanzinduktanz für eine Kabelverbindung nach Anspruch 1, **dadurch gekennzeichnet, dass** der Teilentladungssignalprozessor Erkennungssignale des kapazitiven Teilentladungserfassungssensors durch die Teilentladungssignalresonanzausgabeeinheit und die Teilentladungssignalresonanzerfassungseinheit erfasst, der Teilentladungssignalprozessor wenigstens einen FPGA und einen Einzelchipmikrocomputer umfasst, der Teilentladungssignalprozessor die erfassten Signale zum Erlangen der Signalstärke im Frequenzbereich verarbeitet; der Teilentladungssignalprozessor die Signaldifferenz des gruppierten Kondensators verarbeitet und eine Position des Auftretens der Teilentladung durch Analysieren der Signalstärke ermittelt.

7. Teilentladungserkennungsvorrichtung mit gegenseitiger Resonanzinduktanz für eine Kabelverbindung nach Anspruch 1, **dadurch gekennzeichnet, dass** eine Verbindungsleitung der Teilentladungssignalresonanzerfassungseinheit und des Teilentladungssignalprozessors eine Signalleitung mit elektromagnetischer Schirmung ist.

8. Verfahren zur Erkennung von Teilentladung mittels gegenseitiger Resonanzinduktanz für eine Kabelverbindung, um eine Teilentladung an der Kabelverbindung zu erkennen, **dadurch gekennzeichnet, dass** es folgende Schritte umfasst:
Bereitstellen einer Teilentladungserkennungsvorrichtung mit gegenseitiger Resonanzinduktanz für eine Kabelverbindung nach einem derAnsprüche 1-7;
Erkennen des Teilentladungssignal erkennt und Ermitteln einer Position des Auftretens der Teilentladung durch die Teilentladungserkennungsvorrichtung mit gegenseitiger Resonanzinduktanz für eine Kabelverbindung.

9. Verfahren zur Erkennung von Teilentladung mittels gegenseitiger Resonanzinduktanz für eine Kabelverbindung nach Anspruch 8, **dadurch gekennzeichnet, dass** der kapazitive Teilentladungserfassungssensor außerhalb der Gummischicht und innerhalb der Kupfergitterschicht der Kabelverbindung bereitgestellt wird und die Kabelverbindung umhüllt; die Teilentladungssignalresonanzausgabeeinheit an der Kupfermantelklebstoffeinfüllöffnung des Kabels bereitgestellt wird und zum Übertragen des Teilentladungssignals aus der äußeren spannungsfesten Hüllschicht des Kabels heraus bereitgestellt wird; die Teilentladungssignalresonanzerfassungseinheit außerhalb der äußeren spannungsfesten Hüllschicht des Kabels bereitgestellt wird und der Position der Teilentladungssignalresonanzausgabeeinheit entspricht.

10. Verfahren zur Erkennung von Teilentladung mittels gegenseitiger Resonanzinduktanz für eine Kabelverbindung nach Anspruch 9, **dadurch gekennzeichnet, dass** der Schritt des Erkennens des Teilentladungssignal erkennt und Ermitteln einer Position des Auftretens der Teilentladung durch die Teilentladungserkennungsvorrichtung mit gegenseitiger Resonanzinduktanz für eine Kabelverbindung ferner umfasst:
Erfassen des Teilentladungssignals durch den kapazitiven Teilentladungserfassungssensor;
Erzeugen von Resonanz durch die Teilentladungssignalresonanzausgabeeinheit und den kapazitiven Teilentladungserfassungssensor und Übertragen des Teilentladungssignal aus der äußeren spannungsfesten Hüllschicht des Kabels heraus;
Empfangen des mittels der Teilentladungssignalresonanzausgabeeinheit aus der äußeren spannungsfesten Hüllschicht des Kabels heraus übertragenen Signals durch die Teilentladungssignalresonanzerfassungseinheit;
Verarbeiten des durch die Teilentladungssignalresonanzerfassungseinheit erfassten Signals und Ermitteln einer Position des Auftretens der Teilentladung durch den Teilentladungssignalprozessor.

## Revendications

1. Un dispositif de détection de décharges partielles résonnant à induction mutuelle pour jonction de câble, comprenant un capteur d'acquisition de décharges partielles (1) et un processeur de signaux de décharges partielles (4), **caractérisé en ce qu'**il comprend en outre une unité de sortie de résonnance de signaux de décharges partielles (2) et une unité d'acquisition de résonnance de signaux de décharges partielles (3), le capteur d'acquisition de décharges partielles et l'unité d'acquisition de résonnance de signaux de décharges partielles sont en raccordement câblé et agencés à l'intérieur d'une couche de gaine de tenue à la tension de la jonction du câble, l'unité de sortie de résonnance de signaux de décharges partielles et l'unité d'acquisition de résonnance de signaux de décharges partielles sont en raccordement câblé, et l'unité d'acquisition de résonnance de signaux de décharges partielles et le processeur de signaux de décharges partielles sont en raccordement câblé et agencés à l'extérieur d'une couche de gaine de tenue à la tension de la jonction du câble.

2. Un dispositif de détection de décharges partielles résonnant à induction mutuelle pour jonction de câble selon la revendication 1, **caractérisé en ce que** l'unité de sortie de résonnance de signaux de décharges partielles est agencée à un port de câble à enveloppe de cuivre rempli de colle afin de transmettre un signal de décharge partielle à l'extérieur de la couche de gaine de tenue à la tension de la jonction du câble ; l'unité d'acquisition de résonnance de signaux de décharges partielles est agencée à l'extérieur de la couche de gaine de tenue à la tension du câble et correspond à la position de l'unité de sortie de résonnance de signaux de décharges partielles.

3. Un dispositif de détection de décharges partielles résonnant à induction mutuelle pour jonction de câble selon la revendication 1, **caractérisé en ce que** l'unité de sortie de résonnance de signaux de décharges partielles et l'unité d'acquisition de résonnance de signaux de décharges partielles utilisent toutes deux une structure intégrée à moulage par injection et comprennent toutes deux une enveloppe, une couche de blindage électromagnétique et une couche de bobine, et la couche de blindage électromagnétique et la couche de bobine sont agencées à l'intérieur de l'enveloppe ; la couche de bobine est constituée de bobines d'induction agencées sur un PCB utilisant une structure à matrice ; les bobines d'induction utilisent une structure à double bobine et un moyen d'enroulement inversé, ainsi que des boucles de force de ligne magnétique à contrainte ; la couche de blindage électromagnétique est en matériau de ferrite ; l'enveloppe est munie d'une structure étanche IP68 ; l'enveloppe est munie d'une sortie de câble, et un piston en caoutchouc est agencé à la sortie de câble et est utilisé pour l'étanchéité.

4. Un dispositif de détection de décharges partielles résonnant à induction mutuelle pour jonction de câble selon la revendication 1, **caractérisé en ce que** le capteur d'acquisition de décharges partielles est un capteur capacitif de décharges partielles, est en PCB flexible, et est muni d'une pluralité de régions de détection à condensateur à mailles, les régions de détection à condensateur à mailles sont enveloppées à l'extérieur d'une couche de caoutchouc et à l'intérieur d'une couche de mailles en cuivre de la jonction du câble dans une structure à matrice et par un moyen d'agencement de distribution formant des variations d'angle ; le PCB flexible pour fabriquer le capteur capacitif d'acquisition de décharges partielles utilise une structure à double-couche, dans lequel la couche proximale de la couche de caoutchouc du câble utilise une structure à mailles, et la couche proximale de la couche à mailles de cuivre utilise une structure intégrée monobloc ; le nombre de mailles des régions de détection à condensateur à mailles dans le capteur capacitif d'acquisition de décharges partielles enveloppant une certaine jonction de câble est un nombre pair, et deux régions de détection mutuellement opposées constituent un groupe ; la structure à mailles du condensateur comprend une structure à mailles circulaires et/ou une structure à mailles polygonales, sans se limiter à la structure à mailles circulaires et à la structure à mailles polygonales, le condensateur utilise également d'autres structures de mailles.

5. Un dispositif de détection de décharges partielles résonnant à induction mutuelle pour jonction de câble selon la revendication 3 ou 4, **caractérisé en ce que** un circuit résonnant est formé par la bobine d'induction dans l'unité de sortie de résonnance de signaux de décharges partielles et le condensateur dans le capteur capacitif d'acquisition de décharges partielles, la bobine d'induction dans l'unité d'acquisition de résonnance de signaux de décharges partielles est couplée à un condensateur, et un signal transmis par l'unité de sortie de résonnance de signaux de décharges partielles est reçu via induction mutuelle entre la bobine d'induction dans l'unité d'acquisition de résonnance de signaux de décharges partielles et la bobine d'induction dans l'unité de sortie de résonnance de signaux de décharges partielles, à une certaine jonction de câble, le nombre de bobines d'induction dans l'unité de sortie de résonnance de signaux de décharges partielles, le nombre de bobines d'induction dans l'unité d'acquisition de résonnance de signaux de décharges partielles, et le nombre de régions de détection à condensateurs à mailles dans le capteur capacitif d'acquisition de décharges partielles sont identiques.

6. Un dispositif de détection de décharges partielles résonnant à induction mutuelle pour jonction de câble selon la revendication 1, **caractérisé en ce que** le processeur de signaux de décharges partielles acquière des signaux de détection du capteur capacitif d'acquisition de décharges partielles via l'unité de sortie de résonnance de signaux de décharges partielles et l'unité d'acquisition de résonnance de signaux de décharges partielles, le processeur de signaux de décharges partielles comprend au moins une matrice de portes programmables (FGPA) ou un micro-ordinateur monopuce, le processeur de signaux de décharges partielles traite les signaux collectés pour obtenir la puissance de signal dans la gamme de fréquences ; le processeur de signaux de décharges partielles traite la différence de signal du condensateur groupé, et situe la position d'occurrence de la décharge partielle en analysant la puissance du signal.

7. Un dispositif de détection de décharges partielles résonnant à induction mutuelle pour jonction de câble selon la revendication 1, **caractérisé en ce qu'**une ligne de connexion de l'unité d'acquisition de résonnance de signaux de décharges partielles et du processeur de signaux de décharges partielles est une ligne de signal de blindage électromagnétique.

8. Un procédé de détection de décharges partielles résonnant à induction mutuelle pour jonction de câble, pour détecter les décharges partielles à la jonction du câble, **caractérisé en ce qu'**il comprend les étapes suivantes :
fournir le dispositif de détection de décharges partielles résonnant à induction mutuelle pour jonction de câble selon l'une quelconque des revendications 1-7 ;
le dispositif de détection de décharges partielles résonnant à induction mutuelle pour jonction de câble détecte le signal de décharge partielle, et situe la position d'occurrence de la décharge partielle.

9. Un procédé de détection de décharges partielles résonnant à induction mutuelle pour jonction de câble selon la revendication 8, **caractérisé en ce que** le capteur capacitif d'acquisition de décharges partielles est agencé à l'extérieur de la couche de caoutchouc et à l'intérieur de la couche à mailles de cuivre de la jonction de câble, et enveloppe la jonction du câble ; l'unité de sortie de résonnance de signaux de décharges partielles est agencée à un port à enveloppe de cuivre rempli de colle du câble afin de transmettre un signal de décharge partielle à l'extérieur de la couche de gaine de tenue à la tension de la jonction du câble ; l'unité d'acquisition de résonnance de signaux de décharges partielles est agencée à l'extérieur de la couche de gaine de tenue à la tension du câble et correspond à la position de l'unité de sortie de résonnance de signaux de décharges partielles.

10. Un procédé de détection de décharges partielles résonnant à induction mutuelle pour jonction de câble selon la revendication 9, **caractérisé en ce que** l'étape de « le dispositif de détection de décharges partielles résonnant à induction mutuelle pour jonction de câble détecte le signal de décharge partielle, et situe la position d'occurrence de la décharge partielle » comprend en outre :
le capteur capacitif d'acquisition de décharges partielles acquière le signal de décharge partielle ;
l'unité de sortie de résonnance de signaux de décharges partielles et l'unité d'acquisition de résonnance de signaux de décharges partielles génèrent une résonnance, et transmettent le signal de décharge partielle à l'extérieur de la couche de gaine de tenue à la tension de la jonction du câble ;
l'unité d'acquisition de résonnance de signaux de décharges partielles reçoit le signal produit à l'extérieur de la couche de gaine de tenue à la tension de la jonction du câble par l'unité de sortie de résonnance de signaux de décharges partielles ;
le processeur de signaux de décharges partielles traite les signaux acquis par l'unité d'acquisition de résonnance de signaux de décharges partielles et situe la position d'occurrence de la décharge partielle.
